# EUROPEAN PATENT APPLICATION

(11) **EP 4 650 089 A1**
(43) Date of publication of application: **19.11.2025**
(21) Application number: 25172039.7
(22) Date of filing: 23.04.2025
(51) Int. Cl.: B23K 9/10, H02J 7/00

(54) **WELDING-TYPE POWER SUPPLY CONFIGURED TO MONITOR A STATE OF HEALTH (SOH) OF A BATTERY**

(30) Priority: 14.05.2024 US 202463647167 P; 12.03.2025 US 202519077843
(71) Applicant: Illinois Tool Works Inc., Glenview IL 60025 (US)
(72) Inventor: KNOENER, Craig Steven, Glenview, 60025 (US); GELLINGS, Beau Daniel, Glenview, 60025 (US)
(74) Representative: HGF

(57) **Abstract**

Disclosed example welding-type power supplies include: power conversion circuitry configured to convert input power to welding-type power; a battery connector configured to couple a battery to the power conversion circuitry to provide the input power; and control circuitry configured to: determine a state of health (SoH) of the battery connected to the battery connector; estimate a remaining lifetime quantity of welding that can be performed with the battery and the power conversion circuitry based on the determined SoH before a condition of the battery reaches a predetermined end-of-lifetime condition; and display the estimated remaining lifetime quantity of welding.

## Description

### RELATED APPLICATIONS

The present application claims the benefit of U.S. Provisional Patent Application Serial No. 63/647,167, filed May 14, 2024, entitled "WELDING-TYPE POWER SUPPLIES CONFIGURED TO MONITOR A STATE OF HEALTH (SOH) OF A BATTERY." The entirety of U.S. Provisional Patent Application Serial No. 63/647,167 is expressly incorporated herein by reference.

### FIELD OF THE DISCLOSURE

This disclosure relates generally to welding systems and, more particularly, welding-type power supplies configured to monitor a state of health (SoH) of a battery.

### BACKGROUND

Battery-powered welding power supplies provide a high degree of mobility to an operator by eliminating the requirement of running a potentially long power cord between the power supply and a source of input power. However, batteries are subject to a limited useful life, and operators are not able to discern the SoH or the state of charge (SoC) of the battery by simply looking at the battery. The inability to understand the state of the battery can result in inefficiencies, such as leaving a battery to charge for longer than necessary, or taking more batteries with the operator to the working site than is necessary to accomplish the welding task.

### SUMMARY

Welding-type power supplies configured to monitor a SoH of a battery are disclosed, substantially as illustrated by and described in connection with at least one of the figures, as set forth more completely in the claims.

### BRIEF DESCRIPTION OF THE DRAWINGS

FIG. 1 is a block diagram of an example hybrid welding-type system in accordance with aspects of this disclosure.
FIG. 2 is a block diagram of an example battery-powered welding-type system in accordance with aspects of this disclosure.
FIG. 3 illustrates an example user interface which may implement the user interface of FIGS. 1 and/or 2 to display a remaining lifetime quantity of welding that can be performed with a connected battery.
FIG. 4 illustrates an example user interface which may implement the user interface of FIGS. 1 and/or 2 to display an upper limit on a quantity of welding that can be performed with a connected battery.
FIG. 5 is a flowchart representative of example machine-readable instructions which may be executed by the control circuitry of FIGS. 1 and/or 2 to display a remaining lifetime quantity of welding that can be performed with a connected battery.
FIG. 6 is a flowchart representative of example machine-readable instructions which may be executed by the control circuitry of FIGS. 1 and/or 2 to display an upper limit on a quantity of welding that can be performed with a connected battery.

The figures are not necessarily to scale. Wherever appropriate, similar or identical reference numerals are used to refer to similar or identical components.

### DETAILED DESCRIPTION

Conventional battery-powered welding power supplies display the charge level of the battery to the operator. However, conventional battery-powered welding power supplies do not provide further information about the battery, which can result in the displayed charge level to mislead the operator. Furthermore, the battery is a consumable item, and operators that wish to use multiple batteries on a welding job site have difficulty determining the states of the batteries in their fleet. As a result, battery replacement can occur more often than necessary, and/or weld operator time is wasted retrieving additional batteries when worn batteries are selected for uses that cannot be supported by those worn batteries.

Disclosed example systems and methods determine and indicate the remaining lifetime weld time and/or charge capacity that can be supported by a battery. Disclosed example battery-powered welding power supplies, systems, and methods have access to data about the battery as well as information about the intended use of the battery (e.g., the discharge to be expected from the battery). In some disclosed examples, a battery-powered welding power supply can estimate the remaining lifetime welding that can be performed with a battery, which is based on the usage history of the battery and the loads to which the battery is to be subject. Disclosed example welding-type power supplies can estimate the remaining lifetime quantity of welding and/or remaining present quantity of welding based on, for example, the ambient temperature, the battery capacity, the battery charge, the power that will be converted at the current weld settings, the thermal profile of the battery, and/or the discharge profile of the battery. These data can all be obtained by the welding-type power supplies via communication with the battery, inputs to the power supply, and/or sensors on the power supply.

The remaining lifetime quantity of welding allows weld operators to exchange batteries at advantageous times, such as when the charge capacity has degraded to a level that is not able to satisfactorily support welding-type operations. Operators would be able to proactively replace batteries as the batteries approach end-of-life, rather than suffer battery-related issues while performing their work. Additionally, weld operators can approximate how much time is needed to complete a weld and compare the time to the remaining quantity of welding indicated by the welding power supply for the battery. This allows an operator to effectively use a limited duty cycle welding power source and gives the operator confidence that the operator is carrying a sufficient amount of battery power to complete the desired task.

Disclosed example welding-type power supplies include: power conversion circuitry configured to convert input power to welding-type power; a battery connector configured to couple a battery to the power conversion circuitry to provide the input power; and control circuitry configured to: determine a SoH of the battery connected to the battery connector; estimate a remaining lifetime quantity of welding that can be performed with the battery and the power conversion circuitry based on the determined SoH before a condition of the battery reaches a predetermined end-of-lifetime condition; and display the estimated remaining lifetime quantity of welding.

In some example welding-type power supplies, the control circuitry is configured to: determine a SoC of the battery; estimate a remaining present quantity of welding that can be performed with the battery and the power conversion circuitry based on the determined SoC; and display the estimated remaining present quantity of welding. In some example welding-type power supplies, the control circuitry is configured to estimate the remaining present quantity of welding based on at least one of an ambient temperature, a capacity of the battery, a voltage setpoint, or a current setpoint.

In some example welding-type power supplies, the control circuitry is configured to: monitor and store battery usage data while the power conversion circuitry is performing welding; and communicate the battery usage data to a battery management system of the replaceable battery. In some example welding-type power supplies, the battery usage data includes at least one of an average discharge rate of the battery, a total time during which a discharge rate of the battery is at least a threshold discharge rate, a peak energy discharge, or an ambient temperature.

In some example welding-type power supplies, the control circuitry is configured to: receive battery usage data from a battery management system of the battery; and determine the SoH of the battery based on the battery usage data. In some example welding-type power supplies, the control circuitry is configured to determine the SoH of the battery based on at least one of a thermal profile of the battery or a discharge profile of the battery. In some example welding-type power supplies, the remaining lifetime quantity of welding is based on a historical usage of the power conversion circuitry.

In some example welding-type power supplies, the remaining lifetime quantity of welding is at least one of hours of welding, a number of welds of a specified size and length, a length of welding wire, a weight of welding wire, or a number of stick electrodes. In some example welding-type power supplies, the control circuitry is configured to: determine the SoH of the battery based on stored battery life data; compare an estimated charge capacity of the battery based on the stored battery life data with a determined charge capacity of the battery; and update the stored battery life data based on the comparison.

Other disclosed example welding-type power supplies include: power conversion circuitry configured to convert input power to welding-type power; a battery connector configured to couple a battery to the power conversion circuitry to provide the input power; and control circuitry configured to: determine a SoH of the battery connected to the battery connector; based on the SoH, estimate an upper limit on a SoC of the battery; and estimate an upper limit on a quantity of welding that can be performed with the battery between charging cycles using the power conversion circuitry based on the upper limit on the SoC; and display the estimated upper limit on the quantity of welding.

In some example welding-type power supplies, the control circuitry is configured to: determine the actual SoC of the battery; estimate a remaining present quantity of welding that can be performed with the battery and the power conversion circuitry based on the determined SoC; and display the estimated remaining present quantity of welding. In some example welding-type power supplies, the control circuitry is configured to estimate the upper limit on the quantity of welding based on at least one of an ambient temperature, a capacity of the battery, a voltage setpoint, or a current setpoint.

In some example welding-type power supplies, the control circuitry is configured to: monitor and store battery usage data while the power conversion circuitry is performing welding; and communicate the battery usage data to a battery management system of the replaceable battery. In some example welding-type power supplies, the battery usage data includes at least one of an average discharge rate of the battery, a total time during which a discharge rate of the battery is at least a threshold discharge rate, a peak energy discharge, or an ambient temperature.

In some example welding-type power supplies, the control circuitry is configured to: receive battery usage data from a battery management system of the replaceable battery; and determine the SoH of the battery based on the battery usage data. In some example welding-type power supplies, the control circuitry is configured to determine the SoH of the battery based on at least one of a thermal profile of the battery or a discharge profile of the battery. In some example welding-type power supplies, the remaining lifetime quantity of welding is based on a historical usage of the power conversion circuitry.

In some example welding-type power supplies, the quantity of welding comprises at least one of hours of welding, a number of welds of a specified size and length, a length of welding wire, a weight of welding wire, or a number of stick electrodes. In some example welding-type power supplies, the control circuitry is configured to: determine the SoH of the battery based on stored battery life data; compare an estimated charge capacity of the battery based on the stored battery life data with a determined charge capacity of the battery; and update the stored battery life data based on the comparison.

As used herein, the term "welding-type power" refers to power suitable for welding, plasma cutting, induction heating, CAC-A and/or hot wire welding/preheating (including laser welding and laser cladding). As used herein, the term "welding-type power supply" refers to any device capable of, when power is applied thereto, supplying welding, plasma cutting, induction heating, CAC-A and/or hot wire welding/preheating (including laser welding and laser cladding) power, including but not limited to inverters, converters, resonant power supplies, quasi-resonant power supplies, and the like, as well as control circuitry and other ancillary circuitry associated therewith.

As used herein, a "bidirectional DC-DC converter" refers to any bidirectional circuit topology that converts voltage up and/or down in a first direction and converts voltage up and/or down in a second direction. Example bidirectional DC-DC converters include buck-boost and/or boost-buck topologies, a SEPIC converter, a Ćuk converter, or the like. For example, a bidirectional DC-DC converter may refer to a DC-DC converter that boosts voltage in one direction and bucks voltage in the opposing direction.

As used herein, the term "recognized battery unit" refers to a battery unit that is approved, authorized, and/or otherwise has identifiable minimum characteristics, such as charge state, nominal voltage, minimum voltage, maximum voltage, and/or charge capacity. Recognition can occur through signaling, measurement, and/or any other mechanism.

As used herein, a "circuit" includes any analog and/or digital components, power and/or control elements, such as a microprocessor, digital signal processor (DSP), software, and the like, discrete and/or integrated components, or portions and/or combinations thereof.

Some battery-powered and hybrid welding power supplies display an indicator of remaining charge in a connected battery. For example, the remaining battery charge may be expressed in terms of percentage of full charge or graphically.

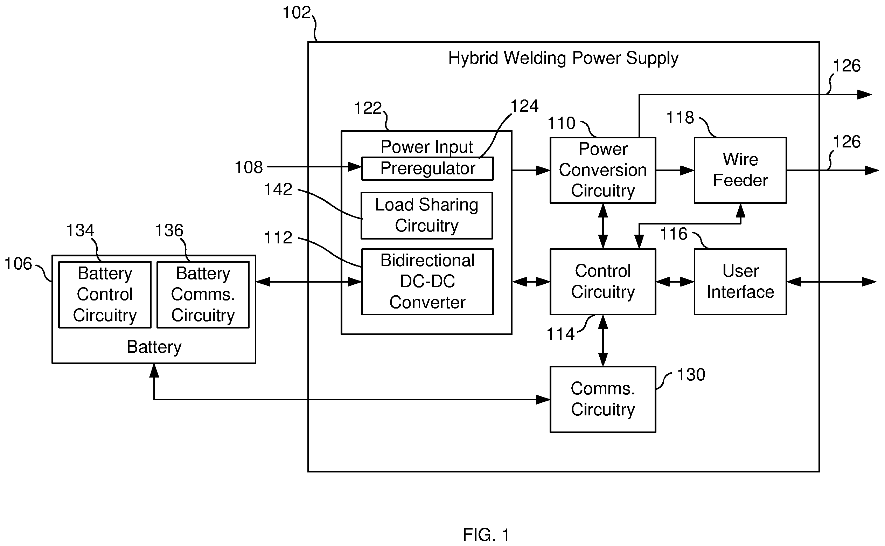

FIG. 1 is a block diagram of an example hybrid welding-type power supply 102. The example hybrid welding-type power supply 102 is connected to one or more batteries 106. The battery 106 may include any type or combination of types of energy storage devices, such as batteries, supercapacitors, thermal energy storage, chemical energy storage, and/or mechanical energy storage devices. While the following examples are discussed with reference to batteries, this disclosure applies to any other type of energy storage that is capable of adaptation for welding.

The hybrid welding-type power supply 102 may also be connected to utility (e.g., AC input) power 108 from a power source such as a generator, a mains power source, a battery-powered inverter supply, and/or any other power source. The hybrid welding-type power supply 102 may be powered by either or both of the battery 106 or the utility power 108 at any given time.

When the hybrid welding-type power supply 102 is connected to both the utility power 108 and to the batteries 106, the hybrid welding-type power supply 102 may charge the batteries 106. Conversely, when energy is required that is not available from the utility power 108, the battery 106 may provide power to the hybrid welding-type power supply 102. In some other examples, the battery 106 is charged separately from the power supply 102 (e.g., via an external charger), and provides power to the power supply 102.

The example hybrid welding-type power supply 102 includes power conversion circuitry 110, a bidirectional DC-DC converter 112, control circuitry 114, a user interface 116, and a wire feeder 118.

The power conversion circuitry 110 is a circuit that converts direct current (DC) power to welding output 126. The DC power used by the power conversion circuitry 110 is received from a power input 122. The power input 122 includes a preregulator 124 and/or the bidirectional DC-DC converter 112, and supplies one or more DC buses with energy (e.g., a DC bus for the output of the preregulator 124 and one or more DC buses for the output of the bidirectional DC-DC converter 112, one DC bus for each battery connection, etc.). The preregulator 124 may include a rectifier to rectify the AC input from the utility power 108. The preregulator 124 further includes circuitry to convert the rectified AC input to the bus voltage for providing power to the power conversion circuitry 110.

In some examples, the power input 122 includes load sharing circuitry 142, multiple converters, and/or multi-stage converters, to supply a DC bus with energy from multiple batteries or other energy storage devices. In some examples, the power input 122 may accept energy from different types of batteries simultaneously in addition to accepting energy from multiple batteries of the same type.

The power conversion circuitry 110 converts the energy present at the DC bus (e.g., from the power input 122) to a weld output 126. For example, the power conversion circuitry 110 may include a switched mode power supply, which is controlled by the control circuitry 114 based on specified weld parameters and feedback.

The bidirectional DC-DC converter 112 is a circuit that converts input power (e.g., from the DC bus powered by the utility power 108) to charge the batteries 106. The bidirectional DC-DC converter 112 also converts the stored power in the batteries 106 to converted power to output to the power conversion circuitry 110 (e.g., via one or more DC buses) for output to the power conversion circuitry 110. In other examples, the bidirectional DC-DC converter 112 is replaced with separate converters (e.g., a buck converter and a boost converter) to charge the battery 106 and to discharge the battery 106.

The control circuitry 114 may include a processor or other logic circuitry. The control circuitry 114 may include any general-purpose central processing unit (CPU), embedded processing system, or system-on-chip from any manufacturer. In some other examples, the control circuitry 114 may include one or more specialized processing units, such as graphic processing units and/or digital signal processors. The control circuitry 114 executes machine-readable instructions that may be stored locally at the processor (e.g., in an included cache), in a random-access memory (or other volatile memory), in a read only memory (or other non-volatile memory such as FLASH memory), and/or in a mass storage device. Example mass storage devices may be a hard drive, a solid-state storage drive, a hybrid drive, a RAID array, and/or any other mass data storage device.

The control circuitry 114 controls the power conversion circuitry 110 to output the weld output 126. The control circuitry 114 controls the bidirectional DC-DC converter 112 to convert power from the power input 122 to charge the batteries 106 and/or controls the bidirectional DC-DC converter 112 to convert power from the batteries 106 to provide the converted battery power to the power conversion circuitry 110. The control circuitry 114 further controls the bidirectional DC-DC converter 112 to charge the batteries 106 when the utility power 108 is available and at least a portion of the utility power 108 is available for charging the batteries 106 (e.g., the utility power 108 is not completely consumed by the power conversion circuitry 110 and/or the wire feeder 118). Conversely, the control circuitry 114 controls the bidirectional DC-DC converter 112 to convert power from the batteries 106 to provide the converted battery power to the power conversion circuitry 110 when a demand for welding power is higher than can be provided by the utility power 108, and/or when the utility power 108 is unavailable.

The example wire feeder 118 includes a wire feed motor to provide electrode wire to the welding operation (e.g., when the welding operation involves a wire feeder, such as when gas metal arc welding, flux cored arc welding, etc.). When the welding operation involves a wire feeder, the control circuitry 114 controls powers the wire feeder 118. The wire feeder 118 may be powered by the weld output 126 or by another output from the power conversion circuitry 110. In some other examples, the wire feeder 118 may be a separate device connected to the weld output 126 external to the hybrid welding-type power supply 102.

The user interface 116 enables input to the hybrid welding-type power supply 102 and/or output from the hybrid welding-type power supply 102 to a user. The control circuitry 114 may indicate the state of charge of the batteries 106 and/or a mode of operation, such as a battery charging mode, an external power welding mode (e.g., welding mode powered by utility power), a combination welding-charging mode (e.g., welding and charging the batteries 106 using utility power 108), a battery powered welding mode, or a hybrid welding mode (e.g., welding boost mode powered by utility power and battery power), of the hybrid welding-type power supply 102 via the user interface 116.

The user interface 116 further includes inputs to allow an operator to specify welding parameters, such as a workpiece thickness, output voltage, output current, wire feed speed, welding wire diameter, welding wire type, welding process, pulse frequency, pulse magnitude, and/or any other desired welding parameter values.

The example control circuitry 114 monitors the properties of the battery 106 and/or utility power 108 to provide information about the batteries, utility power, and welding capacity to the operator. For example, as the power available to the power input 122 from the batteries 106 increases, the control circuitry 114 may determine that thicker materials can be welded, a longer time, length, and/or number of welds of a given length are available to weld for a given set of parameters, use of the utility power 108 can be decreased, the types of usable weld processes increases, the usable consumable sizes (e.g., electrode diameters) increase, and/or other enhancements and/or augmentations to welding may become available. Conversely, as the power available from the batteries 106 decreases, the control circuitry 114 may determine that the thickness of materials that can be welded decreases, less time is available to weld for a given set of parameters, more utility power 108 may be needed, the types of usable weld processes are limited, the usable consumable sizes (e.g., electrode diameters) decrease, and/or the hybrid welding-type power supply 102 becomes otherwise limited.

The control circuitry 114 receives and uses properties of the batteries 106 to determine welding capacity, supported values for welding parameters, and/or alternatives to unsupported values for welding parameters. To determine the properties of the batteries 106, the example hybrid welding-type power supply 102 includes communications circuitry 130. The example communications circuitry 130 may include a network interface and/or an I/O interface. An example network interface includes hardware, firmware, and/or software to connect the communications circuitry 130 to a communications network such as the Internet. For example, the network interface of the communications circuitry 130 may include IEEE 802.X-compliant wireless and/or wired communications hardware for transmitting and/or receiving communications. An example I/O interface includes hardware, firmware, and/or software to connect one or more I/O devices to the control circuitry 114 for providing input to the control circuitry 114 and/or providing output from the control circuitry 114. For example, the I/O interface may include a graphics processing unit for interfacing with a display device, a universal serial bus port for interfacing with one or more USB-compliant devices, a FireWire, a field bus, and/or any other type of interface. Example I/O device(s) may include a keyboard, a keypad, a mouse, a trackball, a pointing device, a microphone, an audio speaker, a display device, an optical media drive, a multi-touch touch screen, a gesture recognition interface, a magnetic media drive, and/or any other type of input and/or output device. The example control circuitry 114 may access a non-transitory machine-readable medium via the I/O interface and/or the I/O device(s). Examples of a machine-readable medium include optical discs (e.g., compact discs (CDs), digital versatile/video discs (DVDs), Blu-ray discs, etc.), magnetic media (e.g., floppy disks), portable storage media (e.g., portable flash drives, secure digital (SD) cards, etc.), and/or any other type of removable and/or installed machine-readable media.

Some types of batteries 106 include battery control circuitry 134 (e.g., a battery management system) and/or battery communications circuitry 136. For example, battery control circuitry 134 may control charging and discharging of individual cells of the battery 106, control internal load balancing between cells of the battery 106, and/or store information about charging and/or discharging of the battery 106 and/or battery communications circuitry 136 may allow for communication of battery information to external devices and/or implement control of one or more aspects of the battery 106 by an external device. The example battery communications circuitry 136 of the battery 106 and/or the communications circuitry 130 of the hybrid welding-type power supply 102 may be configured to communicate through any wired or wireless techniques. For example, the battery communications circuitry 136 and/or the communications circuitry 130 may communicate via serial communications through the battery contacts. In other examples, the battery communications circuitry 136 and/or the communications circuitry 130 may communicate wirelessly via radio frequency identification (RFID), near field communications (NFC), Bluetooth^{®}, and/or any other close-proximity communications, or any other desired wireless communications technique.

The battery control circuitry 134 and the battery communications circuitry 136 communicate to the welding-type power supply 102 the voltage, current, overvoltage threshold, undervoltage threshold, temperature, discharge maximum temperature, discharge recovery temperature, usage history, and/or other information about the battery 106. For example, the battery control circuitry 134 may monitor and store battery usage data, such as battery charging history and/or battery discharging history. The battery usage data may include an average discharge rate of the battery, a total time during which a discharge rate of the battery is at least a threshold discharge rate, a peak energy discharge, and/or an ambient temperature during use of the battery.

In some examples, the control circuitry 114 monitors battery usage data during welding operations, and communicates the monitored battery usage data to the battery control circuitry 134 for storage. As a result, the battery usage data may follow the battery 106 as the battery 106 is used in different welding power supplies, and different power supplies can determine the SoH of the battery 106.

The example power input 122 may further include load sharing circuitry 142. The load sharing circuitry 142 controls a balance of power input from the utility power 108 and the battery 106. For example, the control circuitry 114 may control the load sharing circuitry 142 to cause relatively more power to be drawn from the utility power 108 to preserve battery life and/or avoid unnecessary battery discharge. The control circuitry 114 may also control the load sharing circuitry 142 to cause relatively more power to be drawn from the battery 106, such as to reduce high electricity costs and/or save fuel when utility power 108 is powered by an engine-driven (or other portable fuel-driven) source.

In some examples, the user interface 116 may provide a utility power selection input that defines different levels of power to be drawn from the utility power 108 (e.g., with the balance drawn from the battery 106). Example utility power levels may include a low utility draw level (e.g., limit utility drawn to only levels necessary to sustain the welding), a medium utility draw level, and a high utility draw level (e.g., limit power drawn from the battery 106).

In some examples, the control circuitry 114 communicates with the battery 106 via the battery communications circuitry 136 to determine whether the battery 106 is a recognized battery unit. For example, the power supply 102 may be configured to operate with certain types of battery packs having specific characteristics. The control circuitry 114 may communicate with the battery control circuitry 134 in the battery 106 via the battery communications circuitry 136 to identify the type of battery pack and, if a type of battery pack is identified, determine whether the identified type is recognized. A battery 106 may be recognized by being authorized, approved, included in a list of battery packs accessible by the control circuitry 114, and/or through any other method of recognition or identification of the battery 106 as suitable.

When the control circuitry 114 detects that the battery 106 is recognized, the control circuitry 114 may control the bidirectional DC-DC converter 112 to charge the battery 106 based on one or more predetermined properties of the battery 106 (e.g., charge state, energy storage capacity, etc.). The control circuitry 114 may also control the bidirectional DC-DC converter 112 to convert power from the battery 106 based on the one or more characteristics of the authorized battery unit to provide the converted power to the power conversion circuitry 110. The control circuitry 114 may, in some examples, control the power conversion circuitry 110 to limit the welding power based on the one or more characteristics of the battery 106.

Conversely, if the control circuitry 114 does not identify the battery 106 as a recognized battery, the control circuitry 114 may enable welding without use of the battery 106, (e.g., control the bidirectional DC-DC converter 112 so as to disable converting power from the battery 106), disable the bidirectional DC-DC converter 112 (e.g., prevent the bidirectional DC-DC converter 112 from charging or discharging the battery 106), and/or display a notification via the user interface 116. The notification may be a simple LED, a text-based message, an image displayed via the display device, an audible alert, and/or any other type of notification.

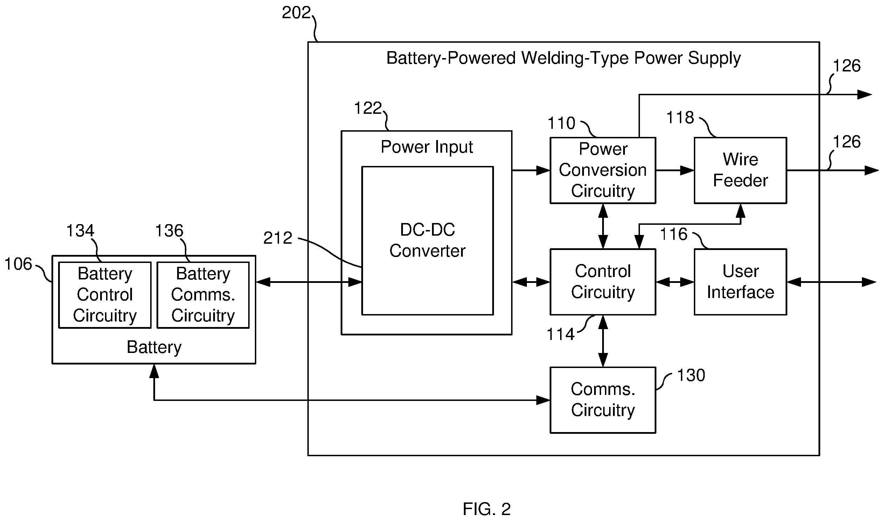

FIG. 2 is a block diagram of a battery-powered welding-type power supply 202. The example battery-powered welding-type power supply 202 is similar to the hybrid welding-type power supply 102 of FIG. 1. The battery-powered welding-type power supply 202 is similar to the hybrid welding-type power supply 102 of FIG. 1, with the exception that the battery-powered welding-type power supply 202 is powered solely by the battery 106 and does not have an input for utility power 108. Accordingly, the example battery-powered welding-type power supply 202 includes a unidirectional DC-DC converter 212 to convert power from the battery 106 to supply the power conversion circuitry 110.

The battery-powered welding-type power supply 202 similarly includes the power conversion circuitry 110, the control circuitry 114, the user interface 116, the wire feeder 118, the power input 122, and the communications circuitry 130, as described above with reference to FIG. 1.

Instead of being connected to external batteries, the example power supplies 102, 202 may use removable batteries and/or integrated batteries.

To aid the operator in determining whether the battery 106 has adequate charge to perform a desired welding-type task, the example power supplies 102, 202 determine a SoH and/or a SoC of a connected battery 106. The example power supplies 102, 202 display a remaining lifetime quantity of welding for the battery 106 and/or a remaining present quantity of welding. The remaining lifetime quantity of welding for the battery 106 represents an amount of welding that is estimated to be able to be performed using the battery 106 before a condition of the battery reaches a predetermined end-of-lifetime condition. The predetermined end-of-lifetime condition may be a selected SoH metric (e.g., remaining battery capacity as a proportion of initial capacity), a threshold battery charge capacity, and/or any other selected value of a battery health metric. The predetermined end-of-lifetime condition may be a default or factory-selected value, or may be adjusted by the operator based on the preferences of the operator for lowest acceptable battery capacity.

The example control circuitry 114 estimates the remaining lifetime quantity of welding based on the current SoH of the battery 106 and the predetermined end-of-lifetime SoH. For example, the control circuitry 114 may access a lifetime curve of the battery 106 to estimate a number of charging cycles remaining until the predetermined end-of-lifetime SoH is reached. The lifetime curve may be based on charge/discharge cycles, numbers of predetermined events (e.g., discharging current more than a threshold discharge current, charging current more than a threshold charge current), durations of predetermined conditions (e.g., time discharging more than a threshold discharge current, time charging at more than a threshold charge current), numbers of inactivated cells, numbers of activated cells, and/or any other data that may affect battery life.

The example control circuitry 114 converts the number of remaining charging cycles into a total charge (over a number of charge/discharge cycles) and a corresponding quantity of welding based on the total charge. In some examples, the control circuitry 114 uses assumptions about the welding parameters (e.g., voltage, current, heat input, etc.) for determining the quantity of welding corresponding to the total charge. Additionally or alternatively, the control circuitry 114 uses assumptions about the charging curve and/or discharging curve used to charge and/or discharge the battery 106 to determining the number of remaining charging cycles, the total charge, and the remaining lifetime quantity of welding. In other examples, the control circuitry 114 may use inputs such as the charging history of the battery 106 and/or discharging history of the battery 106 (e.g., stored by the battery control circuitry 134), welding parameter inputs via the user interface 116, and/or historical welding parameters (e.g., stored by the battery control circuitry 134 and/or by the control circuitry 114), and/or any other inputs and/or stored information related to charging and/or discharging of the battery 106.

In some examples, the user interface 116 enables an operator to input assumed values for determining the remaining lifetime quantity of welding for the battery 106 based on the SoH. For example, the user interface 116 may allow the operator to input characteristics of the charging protocols for the battery (e.g., a charging current or curve that favors extending battery life, a charging current or curve that favors rapid charging, etc.) and/or input characteristics of the discharging of the battery 106 (e.g., use in battery-only welding, use in hybrid welding, use with multiple batteries, welding voltage, welding current, etc.), which affect the number of remaining charging cycles, the total charge, and/or the remaining lifetime quantity of welding. The user interface 116 may also enable the operator to input characteristics of a weld to be performed, such as a workpiece material type, a workpiece thickness, a welding process type, an electrode type, and/or an electrode size, which may affect the amount of welding that can occur for a given amount of charge.

The user interface 116 displays the remaining lifetime quantity of welding, such as via a display screen or other output device. The remaining lifetime quantity of welding may be displayed in units of time (e.g., minutes or hours of welding), in units of length (e.g., inches of welding), and/or in units of welding consumables (e.g., inches of wire, number of stick electrodes, etc.). As discussed above, the control circuitry 114 may convert the calculated total charge for the battery 106 to lifetime welding capacity based on assumed welding parameters and/or input welding parameters. For example, a higher material thickness input would result in a lower quantity of welding than a thinner material.

Using the displayed remaining lifetime quantity of welding, a weld operator may select the battery 106 from multiple available batteries depending on the weld operator's preferences for battery usage. For example, the weld operator may prefer to select a battery that has a higher remaining lifetime quantity of welding over a battery that has a lower remaining lifetime quantity of welding for a particular welding operator or job. The weld operator may also use the remaining lifetime quantity of welding to determine when to replace a particular battery or order a replacement battery in anticipation of replacing the battery.

In addition or as an alternative to determining the remaining lifetime quantity of welding, the example control circuitry 114 may estimate an upper limit on the SoC of the battery 106 (e.g., a present charge capacity of the battery 106) based on the SoH of the battery 106, and estimate a quantity of welding that can be performed using the battery 106 based on the estimated upper limit. For example, while the battery 106 may be charged to a certain proportion (e.g., 50%) of the present capacity of the battery 106, the capacity of the battery 106 decreases over a lifetime of the battery 106. As a result, the battery 106 decreases in capability to supply charge for welding-type operations. The example control circuitry 114 estimates the remaining quantity of welding (e.g., based on actual charge in the battery 106) and an upper limit on the quantity of welding of the battery 106 (e.g., based on charge capacity of the battery 106). Using the upper limit on the quantity of welding, an operator may determine whether the battery 106 is capable of being sufficiently charged to perform a desired welding task or job, or if additional or different batteries should be used instead of the connected battery 106.

The example control circuitry 114 references battery life data to determine the SoH of the battery. The battery life data may be stored in a local storage device and/or accessible via the communications circuitry 130 from an external computing device (e.g., via a network). In some examples, the battery life data relates battery usage data to the SoH of the battery 106. Example battery usage data that may be reflected in the battery life data include the average charge rate and/or discharge rate of the battery 106, a total time during which a charge rate and/or the discharge rate of the battery 106 is at least a threshold charge rate or discharge rate, a peak energy discharge, and/or an ambient temperature during operation of the battery 106. The example battery life data may be represented in a table and/or using a set of weighted factors in an algorithm.

In some examples, the control circuitry 114 compares the battery usage data to the stored battery life data to estimate a SoH of the battery 106. The control circuitry 114 may compare an expected charge capacity of the battery 106 based on the battery usage data to the actual charge capacity observed on the battery 106. In some examples, the control circuitry 114 may obtain the actual charge capacity from the battery control circuitry 134, and/or may determine the actual charge capacity based on charging and/or discharging curves. The control circuitry 114 may correct or update the stored battery life data based on differences between the expected charge capacity and the actual charge capacity to continuously improve the estimates of the remaining lifetime quantity of welding and/or the upper limit on the quantity of welding.

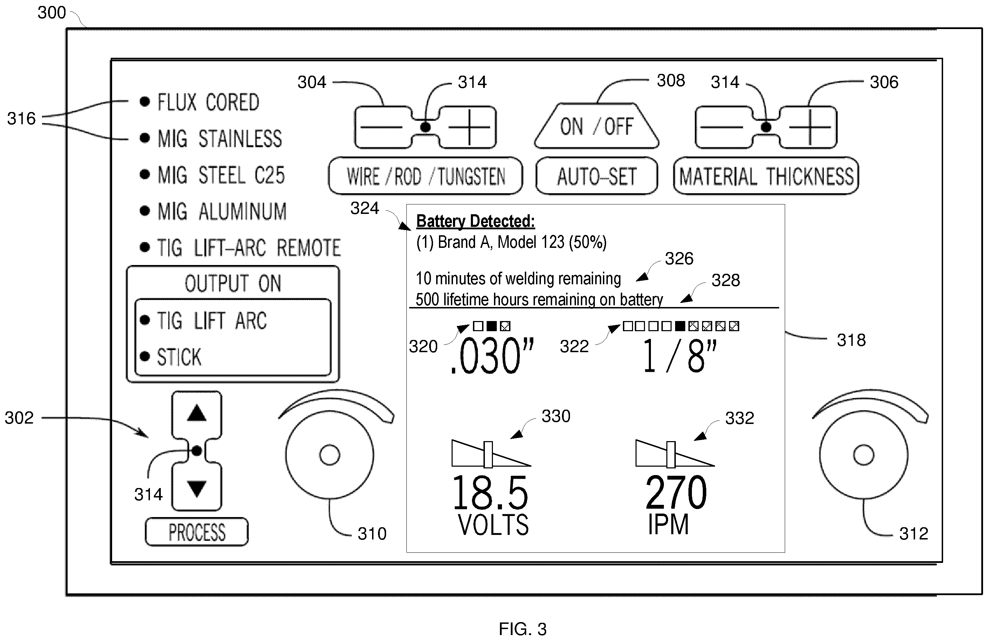

FIG. 3 illustrates an example user interface which may implement the user interface 116 of FIGS. 1 and/or 2 to display a remaining lifetime quantity of welding that can be performed with a connected battery 106.

To enable an operator to specify welding parameters, the example user interface 300 includes a welding process selector 302, an electrode diameter adjustor 304, a material thickness adjustor 306, an Auto-Set selector 308, and welding parameter adjustment dials 310, 312.

The welding process selector 302 allows an operator or other user to select from a plurality of welding processes. For example, as depicted in FIG. 3, the welding process selector 302 may allow an operator to choose from welding processes, such as a stick welding process, a flux cored welding process, one or more metal inert gas (MIG) welding processes, one or more tungsten inert gas (TIG) welding processes, etc. In addition to general welding processes, in some examples, the welding process selector 302 may also allow the operator to select the material of the welding electrode. For example, the operator may further select a stainless steel, another type of steel, an aluminum electrode, and/or any other specific type of electrode for implementing the MIG process. In some examples, the welding process selector 302 may also allow an operator to select a desired combination of welding process (e.g., stick, MIG, TIG, etc.), electrode material type (e.g., steel, aluminum, etc.), and gas type (e.g., C25, C100, Argon, etc.), and subsequently elect to enable the Auto-Set function of the welding-type power supply 102 to automatically set the appropriate voltage and wire feed speed and/or amperage welding parameters. Example Auto-Set functionality is disclosed in greater detail in U.S. Patent Number 8,604,389, which is herein incorporated by reference in its entirety.

The electrode diameter adjustor 304 allows selection of a diameter or size of a welding electrode, such as an electrode wire, an electrode rod, or tungsten electrode, depending on the type of welding process type selected. In the illustrated example, the electrode diameter adjustor 304 includes a "+" pushbutton to increase the electrode diameter setting and a "-" pushbutton to decrease the electrode diameter setting. The material thickness adjustor 306 allows selection of a material thickness of the workpiece. The material thickness adjustor 306 may include a "+" pushbutton to increase the material thickness setting and a "-" pushbutton to decrease the material thickness setting. The electrode diameter and material thickness settings, in conjunction, have an effect on the voltage and amperage (i.e., electrical current) required to perform a given welding procedure.

An operator may select the Auto-Set function via the Auto-Set selector 308. When the Auto-Set feature is enabled (e.g., activated by the operator), the operator may only be required to input the respective electrode diameter and material thickness settings for the power conversion circuitry 110 to automatically adjust (e.g., increase or decrease) voltage, wire feed speed, amperage, and/or other parameters to appropriate settings. The Auto-Set selector 308 may be, for example, an on/off electrical switch or on/off pushbutton, which may be activated or deactivated, to allow the operator to enable or disable the Auto-Set function.

In the example of FIG. 3, the user interface 300 may include one or more light indicators 314 (e.g., LEDs in certain embodiments) to indicate whether the Auto-Set function is enabled or disabled. For example, in performing a MIG welding process, the operator may select the Auto-Set function, via the Auto-Set selector 308 and the one or more light indicators 314 may display a blue light, for example, or other indication to the operator that the Auto-Set function is enabled. Similarly, in some examples, the welding process selector 302 may be associated with a plurality of light indicators 316, each light indicator 316 being spatially aligned with a label corresponding to a respective welding process (e.g., "FLUX CORED", "MIG STAINLESS", and so forth). Manipulation of the welding process selector 302 changes the selected welding process, and the light indicator 316 that corresponds to the selected welding process displays, for example, a blue light, to indicate that the corresponding welding process has been selected.

The user interface 300 further includes a display screen 318 to output or convey information to the operator. The display screen 318 may be any display device capable of displaying visual graphical objects and/or alphanumeric texts relating to the setting of welding parameters, real-time operational statuses of the welding-type power supplies 102, 202, etc. For example, the display screen 318 may be a liquid crystal display (LCD) screen, an organic LED (OLED) display, and/or any other type of display capable of outputting information to the operator. In the example of FIG. 3, the display screen 318 displays a selected electrode diameter (e.g., .030"), a selected material thickness (e.g., 1/8"), a selected power source welding voltage (e.g., 18.5 volts), and a selected wire feed speed (e.g., 270 inches per minute).

In some examples, any of the welding process selector 302, the electrode diameter adjustor 304, the material thickness adjustor 306, the Auto-Set selector 308, the welding parameter adjustment dials 310 and 312, may be displayed as graphical input devices on the display screen 318 (e.g., graphical buttons, graphical sliders, graphical knobs, etc.) instead of, or in addition to, as physical input devices. For example, the display screen 318 may be a touchscreen configured to receive inputs from a user via such graphical input devices that are displayed on the display screen 318.

When the Auto-Set selector 308 is enabled, the display screen 318 may automatically display acceptable ranges of values of welding voltage and wire feed speed and/or amperage based on inputs of the required electrode diameter and/or material thickness parameters (e.g., which are set based upon manipulation of the electrode diameter adjustor 304 and the material thickness adjustor 306). As used herein, an acceptable welding parameter value range may be a range of values within which the power conversion circuitry 110 holds the voltage and wire feed speed and/or amperage in response to an entered or estimated value of the electrode diameter and material thickness parameters, such that a weld may be effectively executed. For example, as depicted in FIG. 3, a welding operator may input an electrode diameter of .030" and a material thickness of 1/8" via the user interface 300. In response, the control circuitry 114 may automatically set appropriate welding parameter settings (e.g., 18.5 volts and 270 inches per minute) to effectively execute a weld for these particular electrode diameter and material thickness characteristics. The appropriate welding parameters may then be displayed via the display screen 318. The user interface 300 also includes welding parameter adjustment dials 310 and 312, which may be used to manually adjust (e.g., increase or decrease) the voltage and wire feed speed parameters and/or amperage parameter within acceptable ranges of values, depending on the particular type of welding process selected using the welding process selector 302.

Conversely, when the Auto-Set selector 308 is disabled, the operator may then manually adjust (e.g. increase or decrease) the welding voltage and wire feed speed parameters within an acceptable range of values (e.g., by manipulating the welding parameter adjustment dials 310 and 312, which correspond to the parameter displayed on the display screen 318 directly above respective welding parameter adjustment dial 310 and 312).

In some examples, the display screen 318 may display a plurality of discrete electrode diameter setting indicators 320 (e.g., displayed as a set of discrete points along a segmented line of a range of potentially selectable electrode diameter settings). A discrete electrode diameter setting indicator 320 corresponding to the currently selected electrode diameter setting (e.g., .030" as illustrated in FIG. 3) is highlighted (e.g., a different color, a different brightness) relative to other setting indicators. Accordingly, when a user selects an electrode diameter via the electrode diameter adjustor 304, the appropriate discrete electrode diameter setting indicator 320 is selected. The plurality of discrete electrode diameter setting indicators 320 are intended to aid the user to know where, within a range of potentially selectable electrode diameter settings, the currently selected electrode diameter setting is. As described herein, the number of discrete electrode diameter setting indicators 320 that are displayed by the display screen 318 is determined based on other settings entered by the user. For example, based on other settings entered via the user interface 300, the display screen 318 will only display discrete electrode diameter setting indicators 320 that correspond to electrode diameter settings that make sense based on these other entered settings.

Similarly, the display screen 318 may display a plurality of discrete material thickness setting indicators 322 (e.g., displayed as a set of discrete points along a segmented line of a range of potentially selectable material thickness settings). A discrete material thickness setting indicator 322 corresponding to the currently selected material thickness setting (e.g., 1/8") is highlighted (e.g., a different color, a different brightness) relative to other setting indicators. Accordingly, when a user selects a material thickness via the material thickness adjustor 306, the appropriate discrete material thickness setting indicator 322 is selected. The plurality of discrete material thickness setting indicators 322 are intended to aid the user to know where, within a range of potentially selectable material thickness settings, the currently selected material thickness setting is. As described herein, the number of discrete material thickness setting indicators 322 that are displayed by the display screen 318 is determined based on other settings entered by the user. For example, based on other settings entered via the user interface 300, the display screen 318 may only display discrete material thickness setting indicators 322 that correspond to material thickness settings that make sense based on these other entered settings.

The example user interface 300 also provides guidance to the operator based on determined properties of the battery 106 and/or determined properties of the utility power 108. In the example of FIG. 3, the display 318 includes a battery indicator 324, a present welding capacity indicator 326, and a remaining lifetime welding indicator 328. The battery indicator 324 may display information about the detected battery, such as the type of the battery (e.g., nominal voltage, brand, model number, etc.) and/or a respective charge level (e.g., remaining charge as a percentage of capacity, remaining ampere-hours, remaining watt-hours, etc.).

The present welding capacity indicator 326 displays an estimated remaining present quantity of welding that can be performed using the battery 106 at the present SoC. The estimated remaining present quantity of welding is determined by the control circuitry 114 based on the SoC, ambient temperature, a capacity of the battery, a voltage setpoint, a current setpoint, and/or any other factors. The present welding capacity indicator 326 is displayed in units of welding, such as minutes of welding, a number of welds of a specified size and length, a length of welding wire, a weight of welding wire, a number of stick electrodes, and/or any other units of welding. The present welding capacity indicator 326 may be adjusted based on the parameters input via the electrode diameter adjustor 304, the material thickness adjustor 306, the Auto-Set selector 308, and/or the welding parameter adjustment dials 310, 312 and based on the determined SoC for the battery 106.

The remaining lifetime welding indicator 328 displays a quantity of welding that can be that can be performed with the battery 106 and the power conversion circuitry 110 based on the determined SoH before a condition of the battery reaches a predetermined end-of-lifetime condition. Similar to the present welding capacity indicator 326, the remaining lifetime welding indicator 328 is displayed in units of welding, such as minutes or hours of welding, a number of welds of a specified size and length, a length of welding wire, a weight of welding wire, a number of stick electrodes, and/or any other units of welding. The remaining lifetime welding indicator 328 may be determined using assumed parameters, charging curves, and/or discharging curves, and/or may be adjusted based on the parameters input via the electrode diameter adjustor 304, the material thickness adjustor 306, the Auto-Set selector 308, and/or the welding parameter adjustment dials 310, 312 and based on the determined SoC for the battery 106. For example, if the operator adjusts the welding parameters to values that would cause excess current draw from the battery 106 (which may depend on whether utility power 108 is used), the remaining lifetime welding indicator 328 may decrease disproportionately due to the expected reduction in battery health that would result from such use.

The control circuitry 114 may determine and display a remaining present quantity of welding that can be performed in terms of the electrode being used. For example, for shielded metal arc welding (SMAW), the control circuitry 114 may calculate a number of stick electrodes that can be welded at the selected parameters and/or conditions (e.g., weld current setpoint, stick electrode diameter, stick electrode type, current limit for utility power 108, hybrid mode or battery-only mode, etc.) with the remaining battery capacity, and display the calculated number of stick electrodes as the present welding capacity indicator 326. For gas metal arc welding (GMAW) or flux cored arc welding (FCAW), the control circuitry 114 may calculate a length in inches, and/or pounds of filler wire, that can be welded at the selected parameters and/or conditions (e.g., weld voltage setpoint, wire feed speed setpoint, pulse parameters, wire electrode diameter, wire electrode type, current limit for utility power 108, hybrid mode or battery-only mode, etc.) with the remaining battery capacity, and display the calculated number of weld inches as the present welding capacity indicator 326. For gas tungsten arc welding (GTAW), the control circuitry 114 may calculate a length in inches that can be welded at the selected parameters and/or conditions (e.g., weld current setpoint, tungsten electrode size, tungsten electrode type, current limit for utility power 108, hybrid mode or battery-only mode, etc.) with the remaining battery capacity, and display the calculated number of weld inches as the present welding capacity indicator 326. As the welding parameters and/or conditions change, the control circuitry 114 recalculates the quantity of welding that can be performed and updates the present welding capacity indicator 326. While example information is displayed by the battery indicator 324, any other properties may be displayed, and/or the operator may be able to navigate one or more menus or interfaces to access additional information or properties of the battery 106 and the properties of the utility power 108.

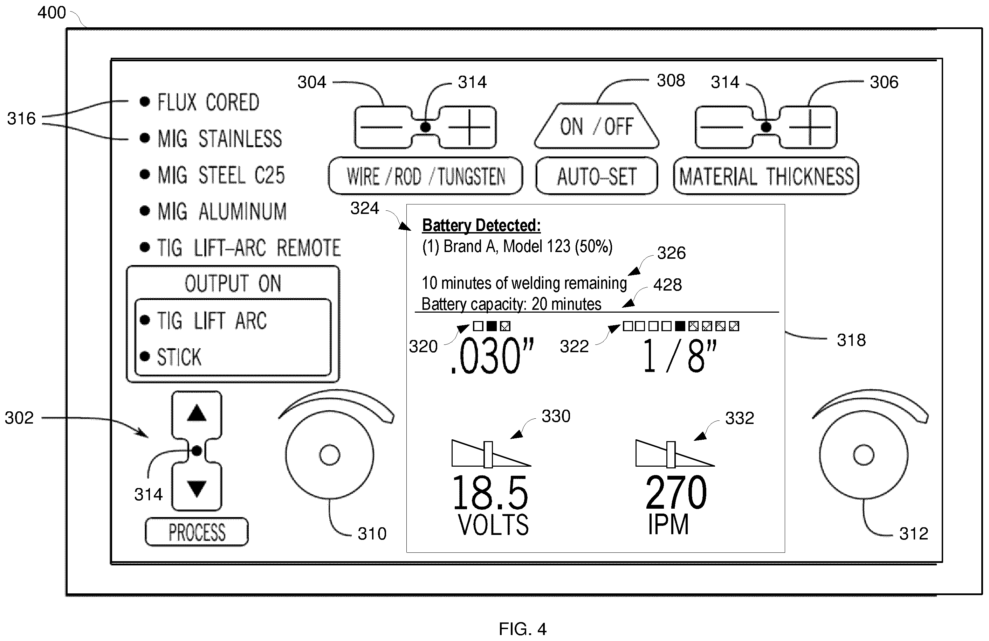

FIG. 4 illustrates an example user interface 400 which may implement the user interface 116 of FIGS. 1 and/or 2 to display an upper limit on a quantity of welding that can be performed with a connected battery 106. The example user interface 400 of FIG. 4 includes the welding process selector 302, the electrode diameter adjustor 304, the material thickness adjustor 306, the Auto-Set selector 308, the welding parameter adjustment dials 310, 312, the light indicators 314, 316, the display screen 318, the electrode diameter setting indicators 320, the material thickness setting indicators 322, the battery indicator 324, and the present welding capacity indicator 326 of FIG. 3.

Instead of, or in addition to, displaying the remaining lifetime welding indicator 328 of FIG. 3, the example interface 400 of FIG. 4 displays a battery welding capacity limit indicator 428. The battery welding capacity limit indicator 428 is calculated by the control circuitry 114 as an upper limit on a quantity of welding that can be performed with the connected battery 106. For example, while the battery 106 may not be charged to the charge capacity of the battery 106 (which may be less than the initial capacity of the battery 106), the battery welding capacity limit indicator 428 indicates an upper limit on the quantity of welding that may be performed with the battery (e.g., at 100% of the present charge capacity of the battery 106).

Similarly to the present welding capacity indicator 326, the example battery welding capacity limit indicator 428 may be based on the SoC, ambient temperature, a capacity of the battery, a voltage setpoint, a current setpoint, and/or any other factors. The present welding capacity indicator 326 is displayed in units of welding, such as minutes of welding, a number of welds of a specified size and length, a length of welding wire, a weight of welding wire, a number of stick electrodes, and/or any other units of welding. The present welding capacity indicator 326 may be adjusted based on the parameters input via the electrode diameter adjustor 304, the material thickness adjustor 306, the Auto-Set selector 308, and/or the welding parameter adjustment dials 310, 312, and based on the determined SoC for the battery 106.

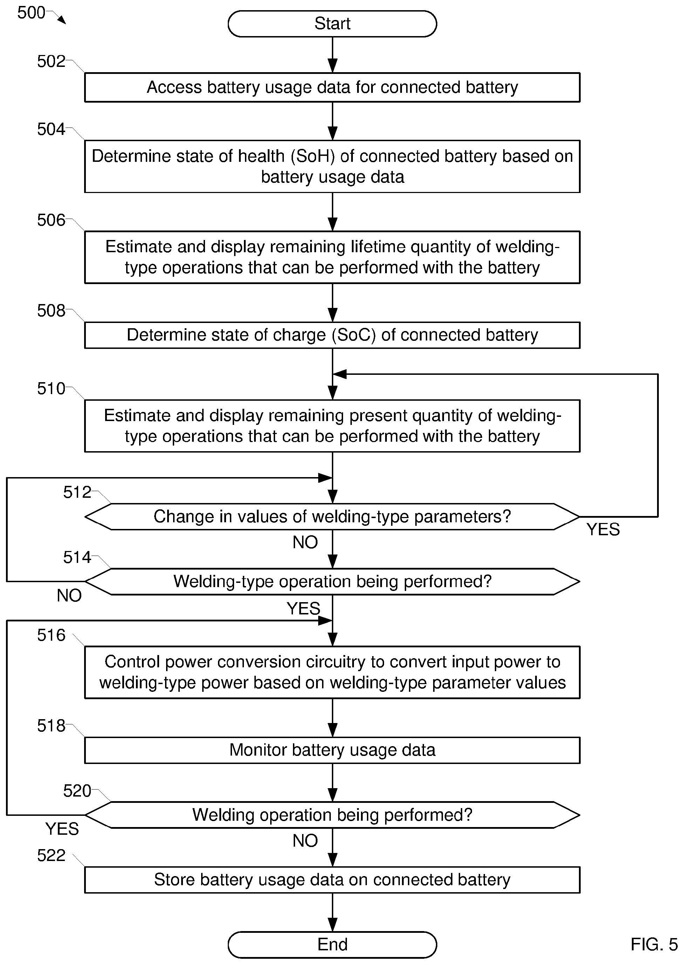

FIG. 5 is a flowchart representative of example machine-readable instructions 500 which may be executed by the control circuitry 114 of FIGS. 1 and/or 2 to display a remaining lifetime quantity of welding that can be performed with a connected battery 106.

At block 502, the control circuitry 114 accesses battery usage data for a connected battery (e.g., the battery 106 of FIG. 1). For example, the communications circuitry 130 may communicate with the battery control circuitry 134 to receive the battery usage data. The battery usage data may include an average discharge rate of the battery, a total time during which a discharge rate of the battery is at least a threshold discharge rate, a peak energy discharge, and/or an ambient temperature during use of the battery.

At block 504, the control circuitry 114 determines a SoH of the connected battery 106 based on the battery usage data. For example, the control circuitry 114 may use stored battery life data in conjunction with the battery usage data to estimate a SoH of the connected battery.

At block 506, the control circuitry 114 estimates a remaining lifetime quantity of welding-type operations that can be performed with the battery based on the SoH. For example, the control circuitry 114 may determine a total charge (through multiple charge/discharge cycles) that can be stored and discharged by the battery 106 until the battery 106 reaches a predetermined end-of-lifetime condition. The predetermined end-of-lifetime condition may be a predetermined charge capacity or other battery health metric. The control circuitry 114 displays the estimated remaining lifetime quantity of welding-type operations (e.g., the remaining lifetime welding indicator 328 of FIG. 3) via the user interface 116 (e.g., the interface 300).

At block 508, the control circuitry 114 determines the SoC of the connected battery 106. For example, the control circuitry 114 may receive SoC data from the battery control circuitry 134 via the communications circuitry 130.

At block 510, the control circuitry 114 estimates a remaining present quantity of welding-type operations that can be performed with the battery 106. For example, the control circuitry 114 may determine, based on the amount of charge in the battery 106, a number of minutes of welding remaining, a number of welds of a specified size and length, a length of welding wire, a weight of welding wire, a number of stick electrodes, and/or another welding quantity. The remaining present quantity of welding-type operations may be based on the physical characteristics of a welding-type operation input into the user interface 116 and/or welding-type parameters input into the user interface 116. The control circuitry 114 displays the estimated present quantity of welding-type operations (e.g., the present welding capacity indicator 326 of FIG. 3) via the user interface 116.

At block 512, the control circuitry 114 determines whether any of the welding-type parameters have changed in value (e.g., via the user interface 116). If the welding-type parameter values have changed (block 512), control returns to block 510 to update the estimated remaining present quantity of welding-type operations.

If the welding-type parameter values have not changed (block 512), at block 514 the control circuitry 114 determines whether a welding-type operation is being performed. If a welding-type operation is not being performed (block 514), control returns to block 512.

If a welding-type operation is being performed (block 514), at block 516 the control circuitry 114 controls the power conversion circuitry 110 to convert input power (e.g., from the battery 106 and/or utility power 108) to welding-type power based on the welding-type parameter values.

At block 518, the control circuitry 114 monitors the battery usage data. For example, the control circuitry 114 may determine the battery discharge rate(s) during the welding-type operation based on the welding-type output power, ambient temperature, time and date, and/or any other usage data.

At block 520, the control circuitry 114 determines whether the welding-type operation is being performed. If the welding-type operation is still being performed (block 520), control returns to block 516. If the welding-type operation is no longer being performed (block 520), at block 522 the control circuitry 114 stores the battery usage data on the connected battery 106. For example, the control circuitry 114 may communicate the battery usage data to the battery control circuitry 134 via the communications circuitry 130. The example instructions 500 then end.

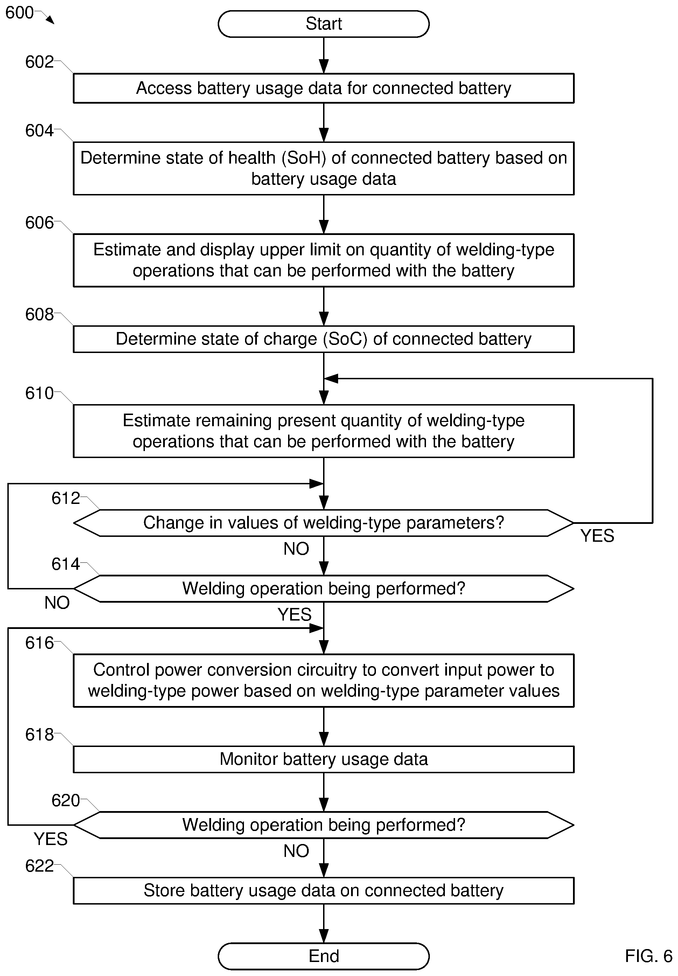

FIG. 6 is a flowchart representative of example machine-readable instructions 600 which may be executed by the control circuitry 114 of FIGS. 1 and/or 2 to display an upper limit on a quantity of welding that can be performed with a connected battery 106.

At block 602, the control circuitry 114 accesses battery usage data for a connected battery (e.g., the battery 106 of FIG. 1). For example, the communications circuitry 130 may communicate with the battery control circuitry 134 to receive the battery usage data. The battery usage data may include an average discharge rate of the battery, a total time during which a discharge rate of the battery is at least a threshold discharge rate, a peak energy discharge, and/or an ambient temperature during use of the battery.

At block 604, the control circuitry 114 determines a SoH of the connected battery 106 based on the battery usage data. For example, the control circuitry 114 may use stored battery life data in conjunction with the battery usage data to estimate a SoH of the connected battery.

At block 606, the control circuitry 114 estimates an upper limit on the quantity of welding-type operations that can be performed with the battery based on the SoH. For example, the control circuitry 114 may determine an expected charge capacity of the battery 106, and determine a corresponding quantity of welding-type operations that can be performed at the expected charge capacity. The control circuitry 114 displays the estimated upper limit on the quantity of welding-type operations (e.g., the battery welding capacity limit indicator 428 of FIG. 4) via the user interface 116 (e.g., the interface 400).

At block 608, the control circuitry 114 determines the SoC of the connected battery 106. For example, the control circuitry 114 may receive SoC data from the battery control circuitry 134 via the communications circuitry 130.

At block 610, the control circuitry 114 estimates a remaining present quantity of welding-type operations that can be performed with the battery 106. For example, the control circuitry 114 may determine, based on the amount of charge in the battery 106, a number of minutes of welding remaining, a number of welds of a specified size and length, a length of welding wire, a weight of welding wire, a number of stick electrodes, and/or another welding quantity. The remaining present quantity of welding-type operations may be based on the physical characteristics of a welding-type operation input into the user interface 116 and/or welding-type parameters input into the user interface 116. The control circuitry 114 displays the estimated present quantity of welding-type operations (e.g., the present welding capacity indicator 326 of FIG. 4) via the user interface 116.

At block 612, the control circuitry 114 determines whether any of the welding-type parameters have changed in value (e.g., via the user interface 116). If the welding-type parameter values have changed (block 612), control returns to block 610 to update the estimated remaining present quantity of welding-type operations.

If the welding-type parameter values have not changed (block 612), at block 614 the control circuitry 114 determines whether a welding-type operation is being performed. If a welding-type operation is not being performed (block 614), control returns to block 612.

If a welding-type operation is being performed (block 614), at block 616 the control circuitry 114 controls the power conversion circuitry 110 to convert input power (e.g., from the battery 106 and/or utility power 108) to welding-type power based on the welding-type parameter values.

At block 618, the control circuitry 114 monitors the battery usage data. For example, the control circuitry 114 may determine the battery discharge rate(s) during the welding-type operation based on the welding-type output power, ambient temperature, time and date, and/or any other usage data.

At block 620, the control circuitry 114 determines whether the welding-type operation is being performed. If the welding-type operation is still being performed (block 620), control returns to block 616. If the welding-type operation is no longer being performed (block 620), at block 622 the control circuitry 114 stores the battery usage data on the connected battery 106. For example, the control circuitry 114 may communicate the battery usage data to the battery control circuitry 134 via the communications circuitry 130. The example instructions 600 then end.

While the examples above are described with reference to welding-type power supplies, the systems and methods disclosed herein could also be implemented in a battery charger, which can determine and display to an operator any of a SoH, a SoC, an estimated remaining lifetime quantity of welding-type operations an estimated remaining present quantity of welding-type operations, and/or an estimated upper limit on quantity of welding-type operations for a battery.

The present methods and systems may be realized in hardware, software, and/or a combination of hardware and software. Example implementations include an application specific integrated circuit and/or a programmable control circuit.

As utilized herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As utilized herein, "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z". As utilized herein, the term "exemplary" means serving as a non-limiting example, instance, or illustration. As utilized herein, the terms "e.g.," and "for example" set off lists of one or more non-limiting examples, instances, or illustrations. As utilized herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.).

While the present method and/or system has been described with reference to certain implementations, it will be understood by those skilled in the art that various changes may be made and equivalents may be substituted without departing from the scope of the present method and/or system. For example, block and/or components of disclosed examples may be combined, divided, re-arranged, and/or otherwise modified. In addition, many modifications may be made to adapt a particular situation or material to the teachings of the present disclosure without departing from its scope. Therefore, the present method and/or system are not limited to the particular implementations disclosed. Instead, the present method and/or system will include all implementations falling within the scope of the appended claims, both literally and under the doctrine of equivalents.

Certain embodiments of the invention are described in the following clauses:
Clause 1 : A welding-type power supply, comprising:
   power conversion circuitry configured to convert input power to welding-type power;
   a battery connector configured to couple a battery to the power conversion circuitry to provide the input power; and
   a control circuitry configured to:
      determine a state of health (SoH) of the battery connected to the battery connector;
      estimate a remaining lifetime quantity of welding that can be performed with the battery and the power conversion circuitry based on the determined SoH before a condition of the battery reaches a predetermined end-of-lifetime condition; and
      display the estimated remaining lifetime quantity of welding.
Clause 2 : The welding-type power supply as defined in claim 1, wherein the control circuitry is configured to:
   determine a state of charge (SoC) of the battery;
   estimate a remaining present quantity of welding that can be performed with the battery and the power conversion circuitry based on the determined SoC; and
   display the estimated remaining present quantity of welding.
Clause 3 : The welding-type power supply as defined in claim 2, wherein the control circuitry is configured to estimate the remaining present quantity of welding based on at least one of an ambient temperature, a capacity of the battery, a voltage setpoint, or a current setpoint.
Clause 4 : The welding-type power supply as defined in claim 1, wherein the control circuitry is configured to:
   monitor and store battery usage data while the power conversion circuitry is performing welding; and
   communicate the battery usage data to a battery management system of the replaceable battery.
Clause 5 : The welding-type power supply as defined in claim 4, wherein the battery usage data comprises at least one of an average discharge rate of the battery, a total time during which a discharge rate of the battery is at least a threshold discharge rate, a peak energy discharge, or an ambient temperature.
Clause 6 : The welding-type power supply as defined in claim 1, wherein the control circuitry is configured to:
   receive battery usage data from a battery management system of the battery; and
   determine the SoH of the battery based on the battery usage data.
Clause 7 : The welding-type power supply as defined in claim 1, wherein the control circuitry is configured to determine the SoH of the battery based on at least one of a thermal profile of the battery or a discharge profile of the battery.
Clause 8 : The welding-type power supply as defined in claim 1, wherein the remaining lifetime quantity of welding is based on a historical usage of the power conversion circuitry.
Clause 9 : The welding-type power supply as defined in claim 1, wherein the remaining lifetime quantity of welding is at least one of hours of welding, a number of welds of a specified size and length, a length of welding wire, a weight of welding wire, or a number of stick electrodes.
Clause 10 : The welding-type power supply as defined in claim 1, wherein the control circuitry is configured to:
   determine the SoH of the battery based on stored battery life data;
   compare an estimated charge capacity of the battery based on the stored battery life data with a determined charge capacity of the battery; and
   update the stored battery life data based on the comparison.
Clause 11 : A welding-type power supply, comprising:
   power conversion circuitry configured to convert input power to welding-type power;
   a battery connector configured to couple a battery to the power conversion circuitry to provide the input power; and
   control circuitry configured to:
      determine a state of health (SoH) of the battery connected to the battery connector;
      based on the SoH, estimate an upper limit on a state of charge (SoC) of the battery; and
      estimate an upper limit on a quantity of welding that can be performed with the battery between charging cycles using the power conversion circuitry based on the upper limit on the SoC; and
      display the estimated upper limit on the quantity of welding.
Clause 12 : The welding-type power supply as defined in claim 11, wherein the control circuitry is configured to:
   determine the actual SoC of the battery;
   estimate a remaining present quantity of welding that can be performed with the battery and the power conversion circuitry based on the determined SoC; and
   display the estimated remaining present quantity of welding.
Clause 13 : The welding-type power supply as defined in claim 12, wherein the control circuitry is configured to estimate the upper limit on the quantity of welding based on at least one of an ambient temperature, a capacity of the battery, a voltage setpoint, or a current setpoint.
Clause 14 : The welding-type power supply as defined in claim 11, wherein the control circuitry is configured to:
   monitor and store battery usage data while the power conversion circuitry is performing welding; and
   communicate the battery usage data to a battery management system of the replaceable battery.
Clause 15 : The welding-type power supply as defined in claim 14, wherein the battery usage data comprises at least one of an average discharge rate of the battery, a total time during which a discharge rate of the battery is at least a threshold discharge rate, a peak energy discharge, or an ambient temperature.
Clause 16 : The welding-type power supply as defined in claim 11, wherein the control circuitry is configured to:
   receive battery usage data from a battery management system of the replaceable battery; and
   determine the SoH of the battery based on the battery usage data.
Clause 17 : The welding-type power supply as defined in claim 11, wherein the control circuitry is configured to determine the SoH of the battery based on at least one of a thermal profile of the battery or a discharge profile of the battery.
Clause 18 : The welding-type power supply as defined in claim 11, wherein the remaining lifetime quantity of welding is based on a historical usage of the power conversion circuitry.
Clause 19 : The welding-type power supply as defined in claim 11, wherein the quantity of welding comprises at least one of hours of welding, a number of welds of a specified size and length, a length of welding wire, a weight of welding wire, or a number of stick electrodes.
Clause 20 : The welding-type power supply as defined in claim 11, wherein the control circuitry is configured to:
   determine the SoH of the battery based on stored battery life data;
   compare an estimated charge capacity of the battery based on the stored battery life data with a determined charge capacity of the battery; and
   update the stored battery life data based on the comparison.

## Claims

1. A welding-type power supply, comprising:
power conversion circuitry configured to convert input power to welding-type power;
a battery connector configured to couple a battery to the power conversion circuitry to provide the input power; and
control circuitry configured to:
determine a state of health (SoH) of the battery connected to the battery connector;
estimate a remaining lifetime quantity of welding that can be performed with the battery and the power conversion circuitry based on the determined SoH before a condition of the battery reaches a predetermined end-of-lifetime condition; and
display the estimated remaining lifetime quantity of welding.

2. The welding-type power supply as defined in claim 1, wherein the control circuitry is configured to:
determine a state of charge (SoC) of the battery;
estimate a remaining present quantity of welding that can be performed with the battery and the power conversion circuitry based on the determined SoC; and
display the estimated remaining present quantity of welding.

3. The welding-type power supply as defined in claim 2, wherein the control circuitry is configured to estimate the remaining present quantity of welding based on at least one of an ambient temperature, a capacity of the battery, a voltage setpoint, or a current setpoint.

4. The welding-type power supply as defined in claim 1, wherein the control circuitry is configured to:
monitor and store battery usage data while the power conversion circuitry is performing welding; and
communicate the battery usage data to a battery management system of the replaceable battery.

5. The welding-type power supply as defined in claim 4, wherein the battery usage data comprises at least one of an average discharge rate of the battery, a total time during which a discharge rate of the battery is at least a threshold discharge rate, a peak energy discharge, or an ambient temperature.

6. The welding-type power supply as defined in claim 1, wherein the control circuitry is configured to:
receive battery usage data from a battery management system of the battery; and
determine the SoH of the battery based on the battery usage data.

7. The welding-type power supply as defined in claim 1, wherein the control circuitry is configured to determine the SoH of the battery based on at least one of a thermal profile of the battery or a discharge profile of the battery.

8. The welding-type power supply as defined in claim 1, wherein the remaining lifetime quantity of welding is based on a historical usage of the power conversion circuitry.

9. The welding-type power supply as defined in claim 1, wherein the remaining lifetime quantity of welding is at least one of hours of welding, a number of welds of a specified size and length, a length of welding wire, a weight of welding wire, or a number of stick electrodes.

10. The welding-type power supply as defined in claim 1, wherein the control circuitry is configured to:
determine the SoH of the battery based on stored battery life data;
compare an estimated charge capacity of the battery based on the stored battery life data with a determined charge capacity of the battery; and
update the stored battery life data based on the comparison.

11. A welding-type power supply, comprising:
power conversion circuitry configured to convert input power to welding-type power;
a battery connector configured to couple a battery to the power conversion circuitry to provide the input power; and
control circuitry configured to:
determine a state of health (SoH) of the battery connected to the battery connector;
based on the SoH, estimate an upper limit on a state of charge (SoC) of the battery; and
estimate an upper limit on a quantity of welding that can be performed with the battery between charging cycles using the power conversion circuitry based on the upper limit on the SoC; and
display the estimated upper limit on the quantity of welding.

12. The welding-type power supply as defined in claim 11, wherein the control circuitry is configured to:
determine the actual SoC of the battery;
estimate a remaining present quantity of welding that can be performed with the battery and the power conversion circuitry based on the determined SoC; and
display the estimated remaining present quantity of welding.

13. The welding-type power supply as defined in claim 12, wherein the control circuitry is configured to estimate the upper limit on the quantity of welding based on at least one of an ambient temperature, a capacity of the battery, a voltage setpoint, or a current setpoint.

14. The welding-type power supply as defined in claim 11, wherein the control circuitry is configured to:
monitor and store battery usage data while the power conversion circuitry is performing welding; and
communicate the battery usage data to a battery management system of the replaceable battery, and optionally wherein the battery usage data comprises at least one of an average discharge rate of the battery, a total time during which a discharge rate of the battery is at least a threshold discharge rate, a peak energy discharge, or an ambient temperature.

15. The welding-type power supply as defined in claim 11, wherein either :
the control circuitry is configured to:
receive battery usage data from a battery management system of the replaceable battery; and
determine the SoH of the battery based on the battery usage data, or wherein the control circuitry is configured to determine the SoH of the battery based on at least one of a thermal profile of the battery or a discharge profile of the battery, or wherein the remaining lifetime quantity of welding is based on a historical usage of the power conversion circuitry, or wherein the quantity of welding comprises at least one of hours of welding, a number of welds of a specified size and length, a length of welding wire, a weight of welding wire, or a number of stick electrodes, or wherein the control circuitry is configured to:
determine the SoH of the battery based on stored battery life data;
compare an estimated charge capacity of the battery based on the stored battery life data with a determined charge capacity of the battery; and
update the stored battery life data based on the comparison.
